# EUROPEAN PATENT APPLICATION

(11) **EP 4 329 446 A1**
(43) Date of publication of application: **28.02.2024**
(21) Application number: 22192196.8
(22) Date of filing: 25.08.2022
(51) Int. Cl.: H05K 7/20

(54) **HEAT SINK FOR AN ELECTRICAL SYSTEM AND APPARATUS WITH SUCH A HEAT SINK**

(71) Applicant: Rolls-Royce Deutschland Ltd & Co KG, 15827 Blankenfelde-Mahlow (DE)
(72) Inventor: ANTAL, Ferenc, 1143 Budapest (HU); DACHER, Péter, 1143 Budapest (HU); Fodor, Tamás Attila, 1143 Budapest (HU); LÉGÁR, András Zsigmond, 1143 Budapest (HU); SÜLÉ, Tibor, 1143 Budapest (HU)

(57) **Abstract**

Embodiments of the invention are shown in the figures, wherein a heat sink (1) for an electrical system (2) with a plurality of electrical modules (20), the heat sink (1) having a plurality of cooling surfaces (10), wherein: along each of the cooling surfaces (10) at least one flow path (F) for conducting a coolant extends within the heat sink (1); one of the plurality of electrical modules (20) of the electrical system (2) is mountable on each of the cooling surfaces (10); and the cooling surfaces (10) are arranged to form a polygon (P).

## Description

The present disclosure relates to a heat sink for an electrical system, to an apparatus with such a heat sink, and to a method for manufacturing such a heat sink.

Heat sinks are widely used in many applications. Some solutions make use of a liquid coolant, others use air for cooling, either passive or active with a fan, for example. There are large numbers of commercially available products, and for many applications there is a suitable off-the-shelf heat sink.

However, common heat sinks are often relatively heavy and only provide the functionality of cooling. Usually, no further functionalities are integrated into the heat sinks.

It is an object to provide an improved heat sink for an electrical system.

According to an aspect there is provided a heat sink for an electrical system, the electrical system having a plurality of electrical modules, the heat sink having a plurality of cooling surfaces, wherein along each of the cooling surfaces at least one flow path for conducting a coolant extends within the heat sink; one of the plurality of electrical modules of the electrical system is mountable on each of the cooling surfaces; and the cooling surfaces are arranged to form a polygon.

This is based on the finding that various electrical systems, such as inverters, can be divided into a number of individual modules, e.g., one inverter module per phase, and that a polygonal arrangement allows at the same time an efficient cooling and a compact and lightweight construction. In turn, an improved heat sink for an electrical system is provided.

The heat sink may be hollow. Optionally, the heat sink defines a polygonal inner volume. The inner volume may be used to arrange components, e.g., of the electrical system, thereby allowing for a particularly compact design and efficient cooling. The cooling surfaces being arranged to form a polygon may be outer surfaces of the heat sink.

For example, the heat sink comprises (e.g., exactly) six cooling surfaces. The polygon may be a hexagon. This allows to cool e.g., six electrical modules efficiently. Alternatively, the heat sink comprises less or more than six cooling surfaces.

The heat sink may further comprise one or more arms, e.g., outwardly extending arms, for mounting the heat sink inside a housing. Alternatively, or in addition, the heat sink may comprise one or more arms, e.g., outwardly extending arms, for mounting parts of the electrical modules. Thus, the heat sink may serve as a structural component, thereby providing a dual use with the synergistic effect of reduced weight.

Optionally, the heat sink defines a passage for a cable. The passage may extend along a length of the heat sink. The channel allows to route the cable in a protected manner without a need for additional components.

Cooling fins may extend along each of the cooling surfaces inside the heat sink defining fluid flow paths. For example, a plurality of cooling fins extend (optionally in parallel) under each cooling surface. This allows a homogenous and efficient cooling. Optionally, the fluid flow paths of one cooling surface are connected (or connectable) with one another via cut-outs in the fins. This allows a more uniform flow and thereby enables an improved cooling efficiency.

One or more, e.g., each of the cooling surfaces can be even (planar). This allows a large contact surface with the respective electrical module for an efficient cooling.

The flow paths for the coolant may be divided into two (e.g., exactly two, or more) sections between a common inlet and a common outlet. By this, a homogenous cooling can be achieved with a simple design.

The heat sink may be made in one piece. This allows a simple assembly of an apparatus with the heat sink, and a simple manufacturing of the heat sink in one process. Alternatively, the heat sink is an assembly of a plurality of parts.

According to an aspect, an apparatus is provided, comprising the heat sink of any aspect or embodiment described herein, and an electrical system with a plurality of electrical modules. Therein, one of the plurality of electrical modules of the electrical system is mounted on each of the cooling surfaces.

The apparatus may further comprise a housing. The heat sink may be mounted within the housing. Optionally, the electrical modules are fixed relative to the housing by means of the heat sink. Thus, the heat sink may have more than one function, including a cooling function and a structural support function.

The apparatus can further comprise a generator and/or a motor. The generator (and/or motor) may be electrically coupled to the electrical system. The electrical system, optionally, is an inverter or, e.g., a power electronics converter. Further, the generator (motor) may be driven by (driving) a bladed rotor, such as a turbine. As a specific example, the apparatus may be an electric auxiliary power unit for a ram air turbine, e.g., for an aircraft.

Optionally, the apparatus comprises a sub-assembly mounted inside the heat sink, particularly within the polygonal inner volume. The sub-assembly may be pre-mountable. The sub-assembly may comprise a first part and a second part, rotatably lockable with respect to one another by means of a bayonet lock. The sub-assembly may be mountable or mounted inside the heat sink in a form-fitting manner (e.g., by means of the polygonal shape of the inner volume), thus preventing unlocking of the bayonet lock. By this, a simple assembly can be achieved, wherein a reduced number of screws or the like is necessary.

For example, a filter, such as an EMI filter, e.g., for DC bus bars, is mounted inside the heat sink, particularly on the sub-assembly. This allows a high quality of the electrical output while maintaining a compact construction.

According to an aspect, a method of manufacturing a heat sink for an electrical system is provided. The electrical system comprises a plurality of electrical modules. The method comprises the step of manufacturing, e.g., by means of additive manufacturing, the heat sink with a plurality of cooling surfaces, such that along each of the cooling surfaces at least one flow path for conducting a coolant extends within the heat sink, one of the plurality of electrical modules of the electrical system is mountable on each of the cooling surfaces, and the cooling surfaces are arranged to form a polygon.

The skilled person will appreciate that except where mutually exclusive, a feature or parameter described in relation to any one of the above aspects may be applied to any other aspect. Furthermore, except where mutually exclusive, any feature or parameter described herein may be applied to any aspect and/or combined with any other feature or parameter described herein.

Embodiments will now be described by way of example only, with reference to the Figures, in which:
- Figures 1 and 2: show a hexagonal heat sink for an electrical system;
- Figures 3 and 4: show the heat sink, wherein six electrical modules of the electrical system are mounted thereon;
- Figures 5 and 6: show an apparatus with a housing, wherein the heat sink and the electrical system are mounted therein;
- Figure 7: shows a passage formed in the heat sink for routing a cable;
- Figure 8: shows arms formed on the heat sink to mount parts of the electrical modules;
- Figure 9: shows an electrical module mounted on the heat sink;
- Figure 10: shows a sectional view of the heat sink, wherein coolant flow paths within the heat sink are visible;
- Figure 11: shows coolant flow paths of the heat sink as well as the direction of flow from an inlet to an outlet;
- Figures 12 and 13: show different sectional views of the heat sink, wherein cooling fins and flow paths therebetween are visible;
- Figure 14: illustrates an additive manufacturing of the heat sink;
- Figures 15 and 16: show details of the inlet of the heat sink;
- Figures 17 and 18: show parts of a sub-assembly of the apparatus which are mountable on one another by means of a bayonet joint;
- Figure 19: shows the apparatus with the heat sink and a mounting plate guiding a coolant;
- Figure 20: shows the mounting plate;
- Figure 21: shows channels in the mounting plate; and
- Figure 22: shows an aircraft with the apparatus.

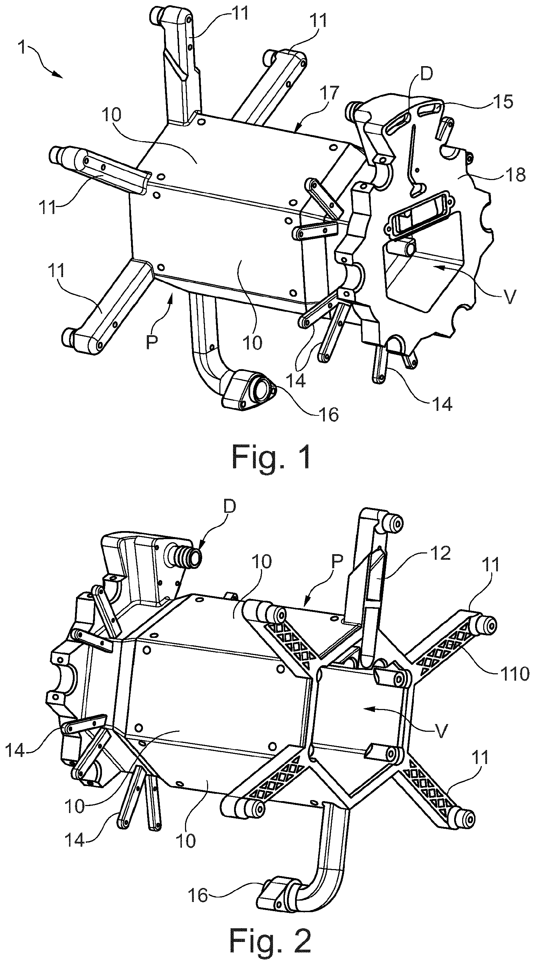

Figures 1 and 2 show a heat sink 1 for cooling an electrical system. The heat sink 1 combines various functions in one component and thereby simplifies the manufacturing and construction.

The heat sink 1 has a plurality of even cooling surfaces 10. The cooling surfaces 10 are outer surfaces. Each cooling surface 10 is for mounting an electrical module of the electrical system. The cooling surfaces 10 are arranged to form a polygon P. In the present example, the heat sink 1 comprises six cooling surfaces 10 and the polygon P is a hexagon. Each cooling surface 10 is arranged opposite and parallel to another cooling surface 10. Each cooling surface 10 is adjacent to two neighboring cooling surfaces 10. That is, each cooling surface 10 is arranged between two other cooling surfaces 10. Each two neighboring cooling surfaces 10 are arranged at an angle with respect to one another. The cooling surfaces 10 have the same shape and size. The cooling surfaces 10 are rectangular. The cooling surfaces 10 are longer than they are wide, i.e., they have a longer side and a shorter side. The longer sides of each two neighboring cooling surfaces 10 are adjacent to one another. An edge connects the adjacent longer sides of each wo neighboring cooling surfaces 10 with one another. The cooling surfaces 10 extend, with their length, in parallel to the central axis.

The heat sink 1 is hollow and has an inner volume V. The inner volume has, at least partially, the shape of a polygon, in this example of a hexagon.

As shown in Figures 1 and 2, the heat sink generally has a main body 17 which comprises the polygon P of cooling surfaces 10, and a flange 18 at one end of the main body 17 (notably, a switched arrangement with the flange 18 at the other side would also be conceivable). The main body 17 extends along a central axis, wherein the polygon extends around the central axis.

The heat sink 1 further comprises arms 11 for mounting the heat sink 1. For a low weight and high stability, the arms 11 have reinforcements 110. The reinforcements are designs as reinforcing ribs in this example. The arms 11 extend from edges between two respective adjacent cooling surfaces 10. The arms 11 are elongate and extend perpendicular to the central axis. The arms 11 are arranged at an end of the heat sink opposite to the flange 18.

Adjacent to the flange 18, the heat sink 1 comprises arms 14 for fixing components to the heat sink 1 as will be described further below.

Furthermore, the heat sink 1 comprises an integrated fluid system. Therefore, the heat sink 1 defines an inlet 15 and an outlet 16. The inlet 15 and the outlet 16 are in fluid communication with one another via channels within the heat sink 1. Further, the heat sink 1 defines a duct D for interfacing with another device that needs to be cooled. The duct D is arranged next to the indel 15.

Moreover, the heat sink 1 defines a passage 12 for a cable. Here, the passage begins at one of the arms 11 at the one end of the heat sink 1. This arm 11 is partly hollow for this purpose. The passage 12 further extends along the length of the heat sink 1 (parallel to the central axis).

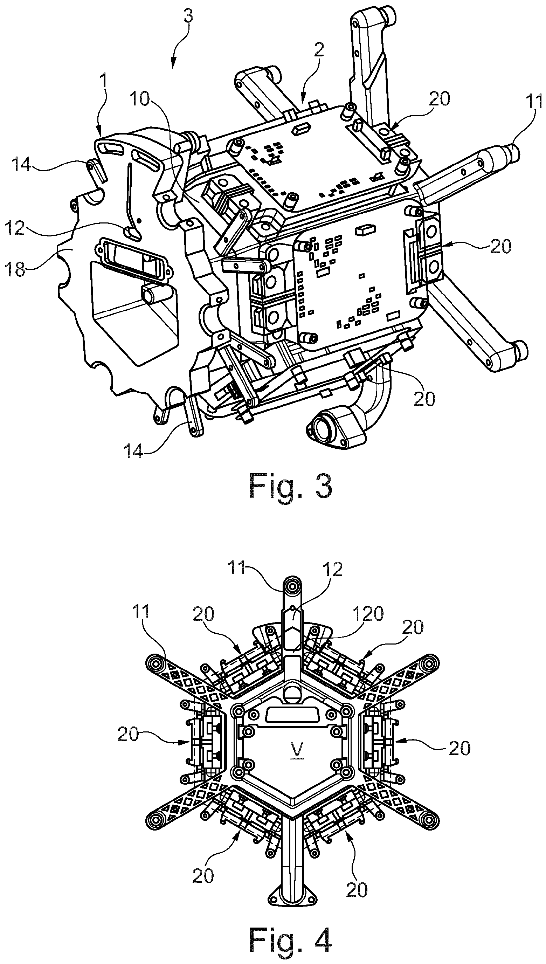

Figures 3 and 4 show the heat sink 1 of Figures 1 and 2 as a part of an apparatus 3 that further comprises an electrical system 2. The electrical system 2 comprises a plurality of electrical modules 20. In this example, the electrical system 2 comprises six electrical modules 20. One of the plurality of electrical modules 20 of the electrical system 2 is mountable and mounted on each of the cooling surfaces 10. Each of the electrical modules 20 is mounted on one of the cooling surfaces 10. The electrical modules 20 of this example all have the same design. Here, the electrical system 2 is an inverter with six phases and each electrical module 20 is an inverter module for one of the phases. Each inverter module 20 of this example utilizes Silicone-Carbide MOSFET power modules and a FPGA-based control.

Each of the electrical modules 20 is in planar contact with the respective cooling surface 10. This allows for an efficient transfer of heat to effectively cool the electrical modules 20. Figures 3 and 4 also show both ends of a cable passage 12 extending through the heat sink 1. The part of the passage 12 which extends through and along the main body 17 and the flange 18 is closed between its two opposite ends. As can be seen particularly in Figure 4, the part of the passage 12 extending along the one of the arms 11 open on one side along its extension. To retain one or more cables in this section, a holder 120 is formed on the passage 12 in the form of a bridge. The holder 120 has the shape of a bar. The holder 120 closes a part of the open section of the passage 12. The holder 120 prevents cables from dislocating.

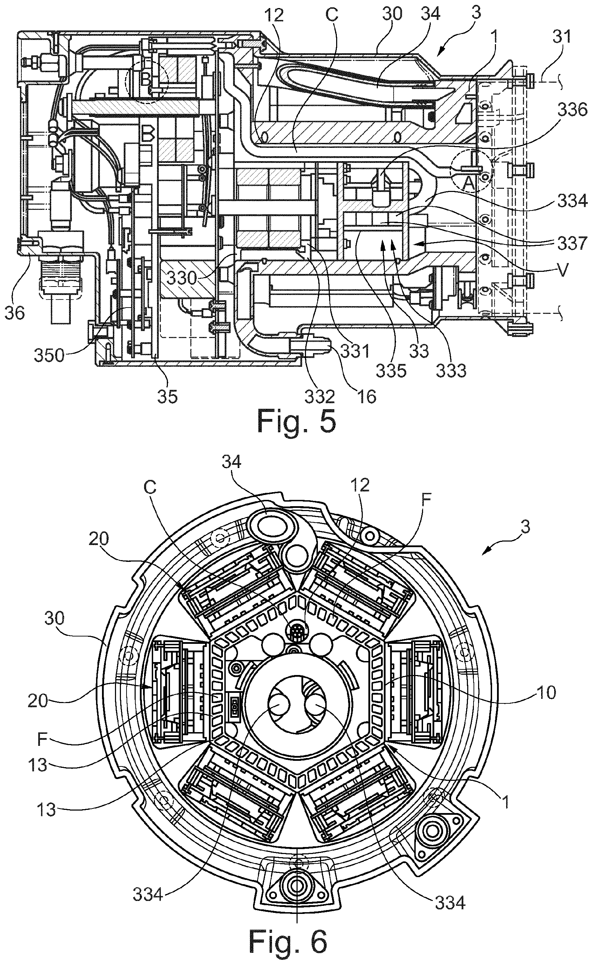

Turning now to Figures 5 and 6, further components and features of the apparatus 3 not shown in Figures 1-4 will be described.

The apparatus 3 is an auxiliary power unit for a ram air turbine (but various other applications are conceivable). Therefore, the apparatus 3 comprises an electrical generator 31. The generator 31, when operated, creates an alternating current which is fed to the electrical system 2 for rectification into a direct current (DC) (e.g., 270 VDC). The generator 31 is mounted on the flange 18 of the heat sink 1. The apparatus may provide more than 1 kW or more than 10 kW electrical output.

The apparatus 3 comprises a housing 30 in which the heat sink 1 with the electrical system 2 is arranged. As can be seen in the sectional views of Figure 5 and Figure 6, the polygonal main body 17 of the heat sink 1 is arranged inside a generally cylindrical section of the housing 30. It can be seen that the polygonal shape allows a particularly compact setup. The electrical modules 20 are arranged between the respective cooling surfaces 10 and the outer housing 30.

A mounting plate 35 is arranged on the side of the heat sink 1 opposite the generator 31. The mounting plate 35 serves for mounting various components such as printed circuit boards, PCBs 350. The mounting plate 35 is fixed to the heat sink 1. Specifically, the mounting plate 35 is fixed to the heat sink 1 via the arms 11 of the heat sink 1. Further, the heat sink 1 is also fixed to the housing 30 via the arms 11. In this example, the arms 11 receive screws from opposite sides in their ends. The electric modules 20 are fixed to the housing 30 via the heat sink 1. The heat sink 1 thus provides structural stability. It increases the stiffness of the inverter, i.e., the electrical system 2.

The end of the housing 30 opposite generator 31 is closed with an end plate 36.

Inside the heat sink 1, in the inner volume V thereof, a sub-assembly 33 is arranged. The sub-assembly 33 comprises a filter, specifically an EMI filter 333 for DC bus bars 334 extending in the inner volume V of the heat sink 1. The DC bus bars 334 have the shape of a U.

The sub-assembly 33 comprises a first part 330 which is fixed to a second part 332 of the sub-assembly 33 by means of a bayonet lock 332 which will be described in more detail further below. A third part 335 of the sub-assembly 33 forms a retainer for ferrites 337 of the EMI filter 333. A fourth part 336 of the sub-assembly 33 serves as a closure of the retainer of the third part 335.

Figure 5 further shows a plurality of sensor cables C routed along the passage 12 from point A to point B. The cables C connect sensors of the generator 31 to a control unit of the assembly 3. The control unit is arranged on the mounting plate 35. The routing of the cables C through the passage 12 provides an electromagnetic shielding of the cables C.

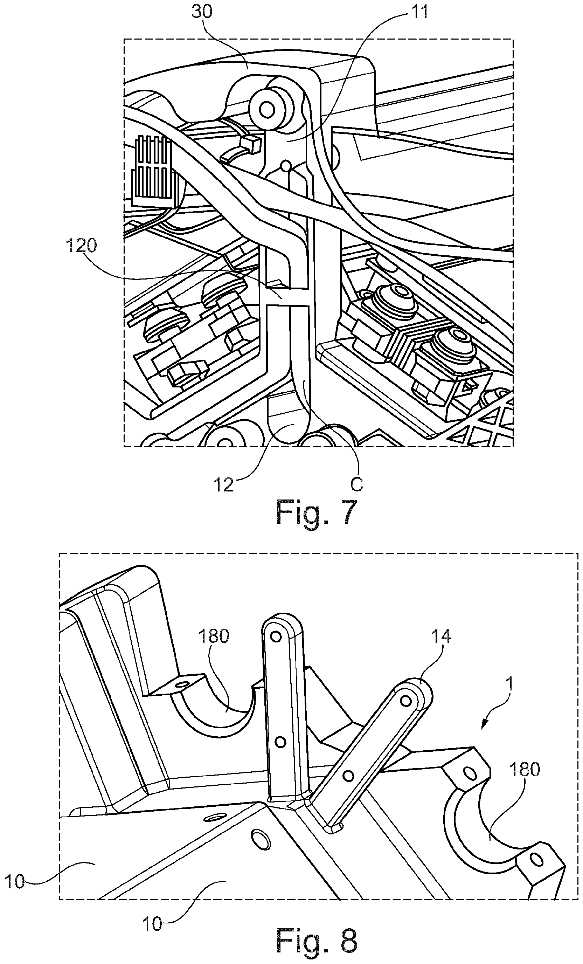

Figure 7 shows the cables C routed along the passage 12 and retained by means of the holder 120 within the arm 11.

Figure 8 shows some of the arms 14 of the heat sink 1 and a part of its flange 18. The arms 14 are arranged at the short sides of the cooling surfaces 10. Further, a receptacle 180 is formed in the flange adjacent to each of the cooling surfaces 10.

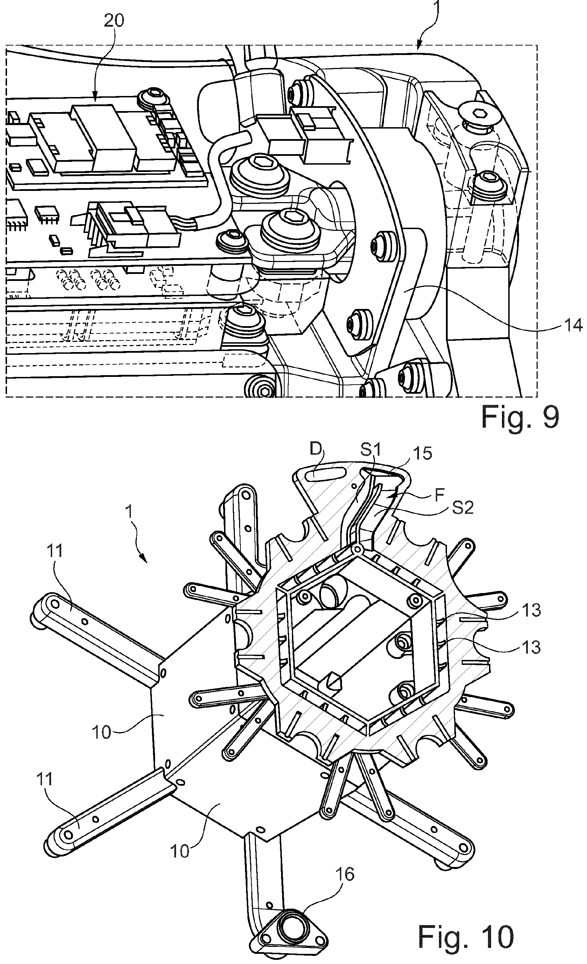

Figure 9 shows approximately the same part of the heat sink 1 as Figure 8, wherein electrical modules 20 are mounted on the cooling surfaces 10. Parts of the electrical modules 20 are mounted on the arms 14. An electrical conductor extends through the respective receptacle 180 of the flange 18. The receptacles 180 serve to hold and cool the conductors.

The apparatus 3 is cooled with a liquid coolant. In the following, flow paths F for coolant extending within the heat sink 1 will be described in detail.

Figure 10 shows, in a sectional view, the flow paths F from the inlet 15 to the main body 17. As can be seen in Figure 10, a wall divides the flow paths F into two sections S1, S2. A first section S1 leads to flow paths F in one of the walls defining one of the cooling surfaces 10. A second section S2 leads to flow paths F in another one of the walls defining another one of the cooling surfaces 10. Both sections S1, S2 lead through flow paths F in two further walls defining two other cooling surfaces 10, respectively.

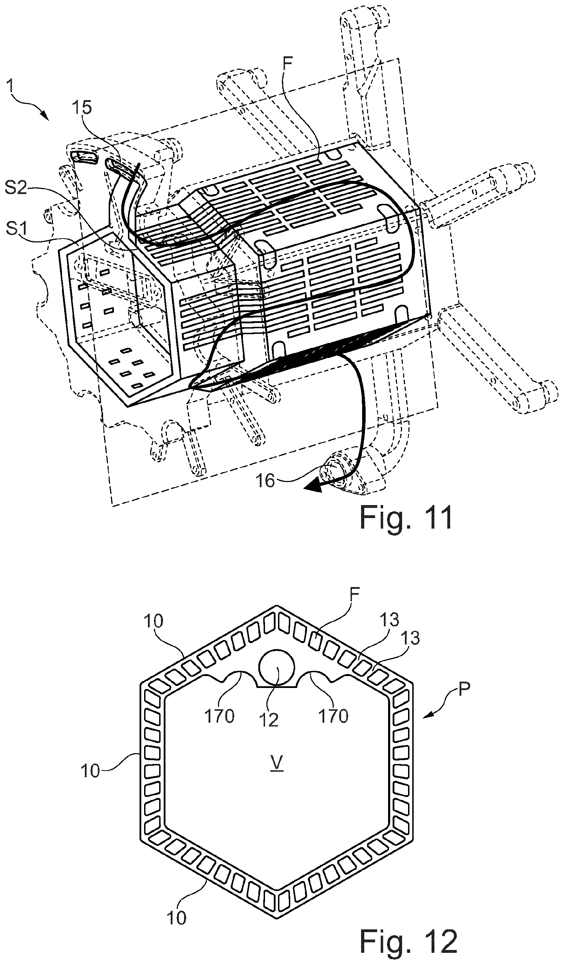

This arrangement of the flow paths F is illustrated in Figure 11, where a flow of coolant through the second section S2 is shown as an example. The coolant enters the inlet 15, is divided into the two sections S1, S2, flows through flow paths F under a first cooling surface 10 until an end, is then directed, via a connection, to flow paths F under a second cooling surface 10, through these flow paths F until another end (at an opposite side of the heat sink 1 compared to the other end). From there, the coolant is directed, via another connection, to flow paths F under a third cooling surface 10, through these flow paths F until the outlet 16.

Figure 12 shows that the individual flow paths F under the cooling surfaces 10 are formed by cooling fins 13. The cooling fins 12 extend radially. Figure 12 also shows receptacles in the main body 17 which hold and cool the DC bus bars 334.

The flow paths F between each pair of cooling fins 13 all have the same cross-sectional area. Thereby, the flow speed is equal in every flow path F.

Notably, instead of the inlet 15 and outlet 16 provided on arms of the heat sink 1, one or more inlets and/or one or more outlets of the heat sink 1 may be formed at end faces of the polygon, i.e., at end faces of one or more of the plural (here six) sides.

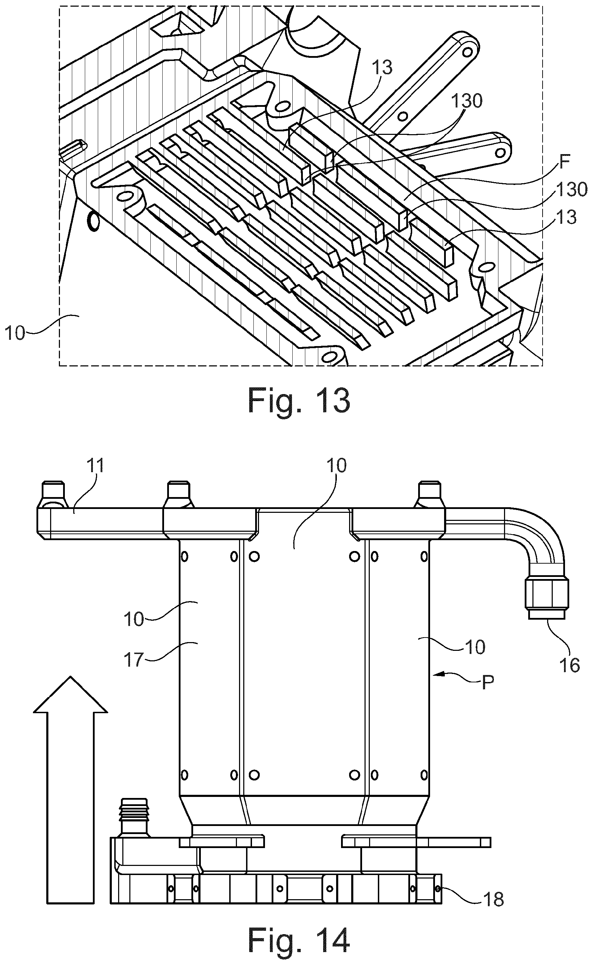

Figure 13 shows the flow paths F under one of the cooling surfaces 10. The cooling fins 13 generally extend in parallel to one another and form the flow paths F therebetween. Cut-outs 130 in the cooling fins 13 improve the flow.

Thus, along (and below) each of the cooling surfaces 10 at least one flow path F for conducting a coolant extends within the heat sink 1. The cooling fins 13 extend along each of the cooling surfaces 10 inside the heat sink 1 defining the fluid flow paths F.

The heat sink 1 is made in one piece. It is made by additive manufacturing, in particular by means of 3d printing. For example, the heat sink 1 is made by laser powder bed fusion or by laser deposition welding. Additive manufacturing simplifies the manufacturing of the geometry of the heat sink 1 described above. The heat sink 1 may be made of metal. For example, the heat sink 1 is made of aluminum or an aluminum alloy.

Figure 14 shows the heat sink 1, wherein an arrow indicates the build direction of the additive manufacturing process. Thus, first the flange 18 is manufactured, then the main body 17 and the arms 11 are made last. Notably, the outlet 16 is first manufactured as separate part, which is connected with the remainder of the heat sink 1 at a later time of the manufacturing.

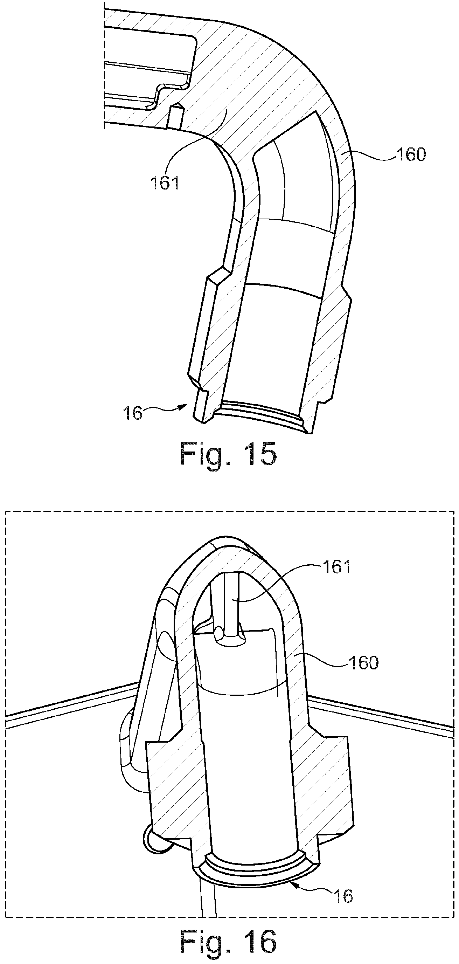

As shown in Figures 15 and 16, a pipe 160 of the outlet 16, connecting the open end of the outlet 16 with the main body 17, forms an inner wall 161. Coolant flowing though the outlet 16 flows along the wall 161 at two opposite sides thereof. The wall 161 supports the pipe 160 during manufacturing.

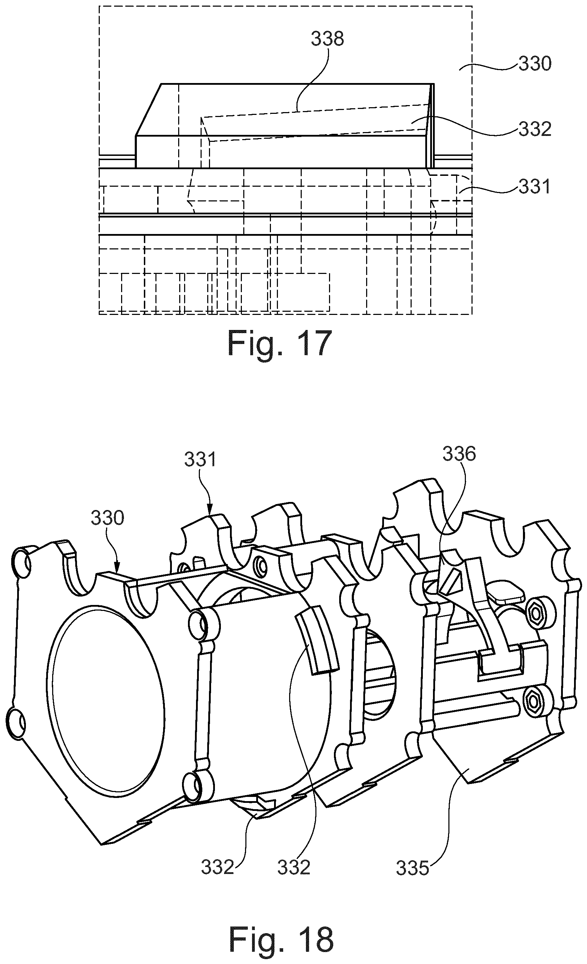

Figure 17 and Figure 18 show the bayonet lock 332 fixing the first and second parts 330, 331 of the sub-assembly 33 on one another. The first part 330 and the second part 331 are rotatably lockable with respect to one another by means of the bayonet lock 332.

The first and second parts 330, 331 further have an outer shape that matches, at least partly, the inner polygonal shape of the heat sink 1. The sub-assembly 33 is mounted in the inner volume V of the heat sink 1 by axially inserting the sub-assembly 33 therein. Thus, the first and second parts 330, 331 are held in the inner volume V in a form-locking manner. Thereby, an unlocking of the bayonet lock 332 is prevented.

For a tight fixation the two engaging sections forming the bayonet lock 332 have sloped surfaces 338.

Figure 18 also shows third part 335 of the sub-assembly 33 which receives the ferrites 337 (see Figure 5). The fourth part 336 serves as a lid and, in the mounted condition, is held on the third part 335 in a form-locking manner.

The first, second, third and fourth parts 330, 331, 335, 336 (more generally, at least one part of the apparatus 3, particularly at least one part of the sub-system 33) is made by additive manufacturing, in particular by 3d printing, specifically, by fused filament fabrication. The material may be a (high temperature resistant) polymer. Notably, the bayonet lock 332 is made by 3d printing.

A pair of screws fixes the third part 335 to the second part 331.

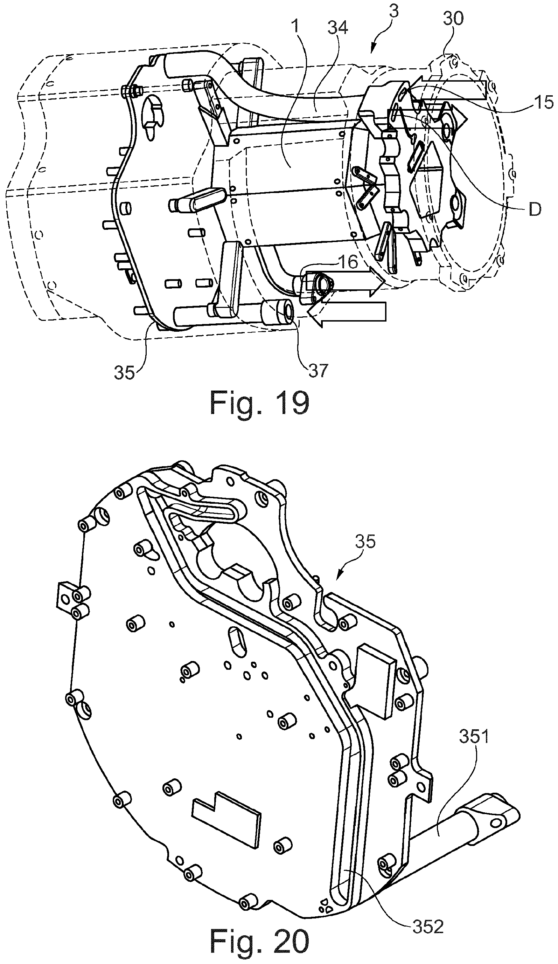

Figure 19 shows the heat sink 1 in the housing 3 and illustrates an inlet 37 of the apparatus 3 for coolant. The inlet 37 leads to a hose 34 via the mounting plate 35. The hose 34 is in fluid connection with the duct D in the heat sink 1. The duct D leads to an inlet of the generator 31. An outlet of the generator 31 leads to the inlet 15 of the heat sink 1, the latter being in fluid connection with the outlet 16 of the heat sink 1 in the way as described above. Thereby, first the generator 31 is cooled, thereafter the inverter.

For guiding the coolant as described from the inlet 37 of the apparatus 3 to the hose 34, the mounting plate 35, shown in more detail in Figure 20 in a partially cut-open view, comprises a tube 351 which leads to at least one, here two, channels 352. The channels 352 extend over the mounting plate 35 to an interface to the hose 34.

The mounting plate 35 provides mechanical stiffness and electrical shielding for the sensitive electronic components. More specifically, the mounting plate 35 provides EMC shielding between the sensitive control unit and other PCBs and the high current electronics parts. It also functions as a cold plate. Furthermore, several PCBs 350 are mounted on it.

The mounting plate 35 is made by additive manufacturing, e.g., by 3d printing. Alternatively, the mounting plate 35 may be divided into several smaller milled and cut parts that could be welded together. The mounting plate 35 is, e.g., made of an aluminum alloy.

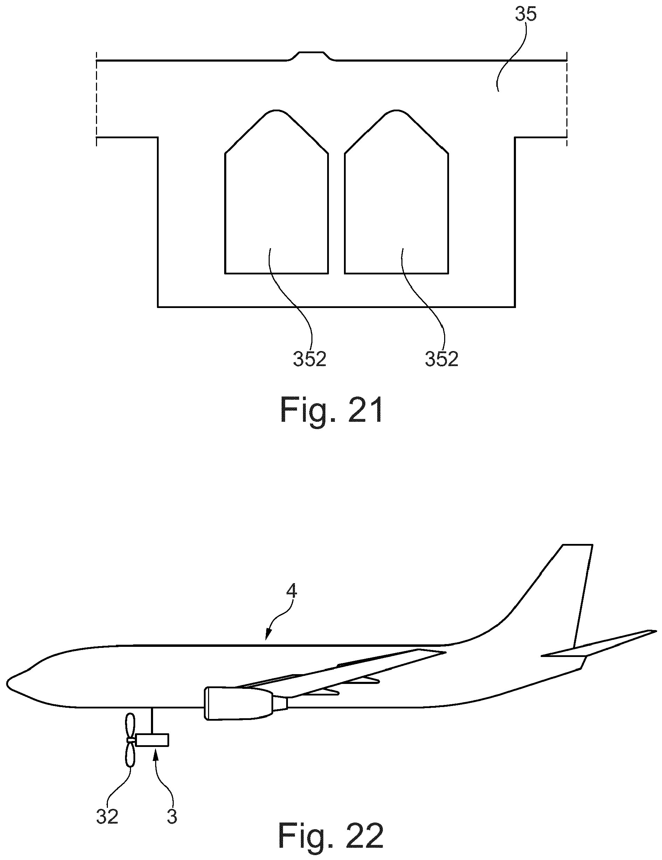

The form of the channels 352 is shown in Figure 21. Accordingly, in the cross-section, the channels 352 have the shape of a rectangle with a triangle, each. Each of the channels have 5 edges. One side of each of the channels 352 is tapered.

Figure 22 shows an aircraft 4 in the form of a passenger aircraft. The aircraft 4 comprises the apparatus 3, which includes a rotor 32 with blades, in the present example the turbine mentioned above. The apparatus 3 may be movable relative to the aircraft 4 body. It may be stowed in the aircraft 4 body. The apparatus 3 can be used to create electrical current for the aircraft 4.

It will be understood that the invention is not limited to the embodiments above described and various modifications and improvements can be made without departing from the concepts described herein. Except where mutually exclusive, any of the features may be employed separately or in combination with any other features and the disclosure extends to and includes all combinations and sub-combinations of one or more features described herein.

### List of reference numbers

- 1: heat sink
- 10: cooling surface
- 11: arm
- 110: reinforcement
- 12: passage
- 120: holder
- 13: cooling fin
- 130: cut-out
- 14: arm
- 15: inlet
- 16: outlet
- 160: pipe
- 161: wall
- 17: main body
- 170: receptacle
- 18: flange
- 180: receptacle
- 2: electrical system
- 20: electrical module
- 3: apparatus
- 30: housing
- 31: generator
- 32: rotor
- 33: sub-assembly
- 330: first part
- 331: second part
- 332: bayonet lock
- 333: EMI filter
- 334: DC bus bar
- 335: third part
- 336: fourth part
- 337: ferrite
- 338: surface
- 34: hose
- 35: mounting plate
- 350: PCB
- 351: tube
- 352: channel
- 36: end plate
- 37: inlet
- 4: aircraft
- C: cable
- D: duct
- F: flow path
- P: polygon
- S1,S2: section
- V: inner volume

## Claims

1. A heat sink (1) for an electrical system (2) with a plurality of electrical modules (20), the heat sink (1) having a plurality of cooling surfaces (10), wherein:
- along each of the cooling surfaces (10) at least one flow path (F) for conducting a coolant extends within the heat sink (1);
- one of the plurality of electrical modules (20) of the electrical system (2) is mountable on each of the cooling surfaces (10); and
- the cooling surfaces (10) are arranged to form a polygon (P).

2. The heat sink (1) according to claim 1, wherein the heat sink (1) is hollow and defines a polygonal inner volume (V).

3. The heat sink (1) according to claim 1 or 2, wherein the heat sink (1) comprises six cooling surfaces (10) and the polygon is a hexagon.

4. The heat sink (1) according to any of the preceding claims, further comprising outwardly extending arms (11) for mounting the heat sink (1) in a housing (30) and/or outwardly extending arms (14) for mounting parts of the electrical modules (20).

5. The heat sink (1) according to any of the preceding claims, wherein the heat sink (1) defines a passage (12) for a cable (C).

6. The heat sink (1) according to any of the preceding claims, wherein cooling fins (13) extend along each of the cooling surfaces (10) inside the heat sink (1) defining fluid flow paths (F), wherein the fluid flow paths (F) of a cooling surface (10) are connectable or connected with one another via cut-outs (130) in the fins (13).

7. The heat sink (1) according to any of the preceding claims, wherein each of the cooling surfaces (10) is even.

8. The heat sink (1) according to any of the preceding claims, wherein the flow paths (F) for the coolant are divided into two or more sections (S1, S2) between a common inlet (15) and a common outlet (16).

9. The heat sink (1) according to any of the preceding claims, wherein the heat sink (1) is made in one piece.

10. An apparatus (3) comprising the heat sink (1) according to any of the preceding claims and an electrical system (2) with a plurality of electrical modules (20), wherein one of the plurality of electrical modules (20) of the electrical system (2) is mounted on each of the cooling surfaces (10).

11. The apparatus (3) according claim 10, further comprising a housing (30), wherein the heat sink (1) is mounted in the housing (30), wherein the electrical modules (20) are fixed to the housing (30) by means of the heat sink (10).

12. The apparatus (3) according to claim 10 or 11, further comprising a motor and/or generator (31) electrically coupled to the electrical system (2), the electrical system (2) being an inverter, wherein the motor and/or generator (31) drives and/or is driven by a bladed rotor (32).

13. The apparatus (3) according to any of claims 10 to 12, wherein a sub-assembly (33) comprising a first part (330) and a second part (331), rotatably lockable with respect to one another by means of a bayonet lock (332), is mounted inside the heat sink (1) in a form-fitting manner, thus preventing unlocking of the bayonet lock (332).

14. The apparatus (3) according to any of claims 10 to 13, wherein an EMI filter (333) for DC bus bars (334) is mounted inside the heat sink (1).

15. A method of manufacturing a heat sink (1) for an electrical system (2) with a plurality of electrical modules (20), the method comprising the step of manufacturing, particularly by means of additive manufacturing, the heat sink (1) with a plurality of cooling surfaces (10), such that along each of the cooling surfaces (10) at least one flow path (F) for conducting a coolant extends within the heat sink (1), one of the plurality of electrical modules (20) of the electrical system (2) is mountable on each of the cooling surfaces (10), and the cooling surfaces (10) are arranged to form a polygon (P).
